# EUROPEAN PATENT APPLICATION

(11) **EP 3 159 897 A1**
(43) Date of publication of application: **26.04.2017**
(21) Application number: 15190629.4
(22) Date of filing: 20.10.2015
(51) Int. Cl.: H01B 1/12, H01L 51/00

(54) **COMPOSITION FOR FORMING TRANSPARENT CONDUCTOR AND TRANSPARENTCONDUCTOR MADE THEREFROM**

(71) Applicant: Solvay SA, 1120 Bruxelles (BE)
(72) Inventor: LEE, Jung-Yul, Gyeonggi-do (KR)
(74) Representative: Mross, Stefan P.M.

(57) **Abstract**

The present invention concerns compositions comprising at least one metal nanowires, at least one π-conjugated conductive polymer, at least one particular neutralization agent, and at least one solvent. The compositions according to the present invention can be used for forming a transparent conductor particularly useful in touch panel application.

## Description

### FIELD OF THE INVENTION

The present invention relates to a conductive composition and to a transparent conductor made from said conductive composition, the transparent conductor being suitable for use in electronic device applications, in particular in touch panels.

### BACKGROUND OF THE INVENTION

Transparent conductors are optically transparent, thin conductive materials. Such materials have wide variety of applications, such as transparent electrodes in displays such as liquid crystal displays (LCD), plasma displays, and organic light-emitting diode (OLED), touch panels, photovoltaic cells, electrochromic devices, and smart windows, as anti-static layers and as electromagnetic interference shielding layers.

Conventional transparent conductors include metal oxide films, in particular indium tin oxide (ITO) film due to its relatively high transparency at high conductivity. However, ITO has several shortcomings, such as high cost during its fabrication because it needs to be deposited using sputtering technique which involves the use of high temperatures and vacuum chambers. Metal oxide films are also fragile and prone to damage even when subjected to minor physical stresses such as bending, and as such, often does not applicable when a flexible substrate on which the metal oxide film is to be deposited is used.

Conductive polymers have a good flexibility and are often considered to be inexpensive because they can be formed by simple processing. Having these characteristics, it is believed that conductive polymer compositions are among the potential candidates to replace ITO film in forming the transparent conductor for various electronic device applications.

Metal nanowires are considered as another promising candidate to replace the commonly-used ITO due to its high dc conductivity and optical transmittance, and good mechanical flexibility, etc.

In US patent application publication No. US 2008/0259262 A1, disclosed are composite transparent conductors which comprise conductive medium based on metal nanowires and a secondary conductive medium based on a continuous conductive film.

Development of conductive composition which can be suitably used for forming high quality transparent conductors, in particular those having not only satisfactory conductivity, transparency, and/or haze, but also an excellent reliability of at least one or all of them, is desired in the art.

### DESCRIPTION OF THE INVENTION

The purpose of the present invention is therefore to provide compositions based on at least one metal nanowires and at least one conductive polymer, the compositions suitable for forming transparent conductors. The compositions according to the present invention can be advantageously used in preparing a transparent conductive layer which exhibits desirable sheet resistance as well as excellent reliability of the sheet resistance for an extended time period. Another purpose of the present invention is to provide conductive compositions which comprise both metal nanowires and conductive polymer in a single composition system. Further purpose of the present invention is to provide conductive compositions which can be suitably used for forming a transparent conductor particularly advantageous for touch panel application.

The present invention relates to compositions comprising (A) at least one metal nanowires, (B) at least one π-conjugated conductive polymer, (C) at least one amine compound having a boiling point of at least 180 °C, and (D) at least one solvent.

The transparent conductor made from the compositions according to the present invention can display good conductivity, transparency, and/or haze. In addition, the transparent conductor of the present invention surprisingly exhibits an outstanding reliability of said properties over an extended time period.

Further, the present invention provides an electronic device, in particular touch panel, comprising the transparent conductor according to the present **invention.**

### DETAILED DESCRIPTION OF THE INVENTION

In the present invention, the term "substrate" is understood to denote in particular a solid, especially a transparent solid, i.e. light transmission of the substrate is at least 70 % (preferably at least 85%, more preferably at least 90 %, still more preferably at least 95%, particularly preferably at least 98%) in the visible light region (400 nm to 700 nm), on which the composition according to the present invention can be deposited. Examples of such substrates include a glass substrate, and transparent solid polymers, for example polycarbonates(PC), polyesters, such as polyethyleneterephthalate(PET), acryl resins, polyvinyl resins, such as polyvinyl chloride, polyvinylidene chloride, and polyvinyl acetals, aromatic polyamide resins, polyamideimides, polyethylene naphthalene dicarboxylate, polysulphones, such as polyethersulfone(PES), polyimides(PI), cyclic olefin copolymers(COC), styrene copolymers, polyethylene, polypropylene, cellulose ester bases, such as cellulose triacetate, and cellulose acetate, and any combination thereof. Preferably, the substrate is in the form of a sheet. In the present invention, the substrate may be rigid or flexible. Examples of the flexible substrate include, but are not limited to, those transparent solid polymers, including polycarbonates, polyesters, polyolefins, polyvinyls, cellulose ester bases, polysulphones, polyimides, and other conventional polymeric films.

In the present invention, a π-conjugated conductive polymer is understood to denote in particular any polymeric materials that conduct electricity. In the compositions according to the invention, the π-conjugated conductive polymers can be, for example, dissolved or dispersed in the solvent. Preferably, the conductive polymers are dispersed in water and/or alcohol.

In the present invention, the π-conjugated conductive polymer may be selected from the group consisting of polyaniline polymers, polypyrrole polymers, polythiophene polymers, and any combination thereof. Preferably, the π-conjugated conductive polymer is at least one polythiophene polymers, in particular poly(3,4-ethylenedioxythiophene)(PEDOT) polymers.

In the present invention, the PEDOT polymer is preferably doped with at least one further compound. One example of such compound for doping includes polymeric acid dopant, in particular a water soluble polymeric dopant. Examples of doped PEDOT polymers include PEDOT doped with lignosulfonic acid (LSA) (PEDOT/LSA), PEDOT doped with polyethyleneglycol (PEG) (PEDOT/PEG), PEDOT doped with polyoxometalate (POM) (PEDOT/POM), PEDOT doped with sufonated polyimide (SPI) (PEDOT/SPI), PEDOT doped with carbon materials, such as activated carbon, graphene and carbon nanotube (CNT) (activated carbon/PEDOT composite, PEDOT/graphene composite, or PEDOT/CNT composite), PEDOT doped with DMSO and CNT (PEDOT/DMSO/CNT), PEDOT doped with tosylate, PEDOT doped with chloride anion, PEDOT doped with NO₃, PEDOT doped with PSS (PEDOT:PSS), PEDOT/PSS doped with pentacene, PEDOT doped with ammonium persulfate (APS) (PEDOT/APS), and PEDOT doped with dimethyl sulfoxide (DMSO) (PEDOT/DMSO), but the present invention is not limited thereto. More preferably, the PEDOT polymer is doped with a polymer having at least one sulfonic acid, such as polystyrene sulfonic acid (PSS).

In the preferred embodiment of the present invention, the π-conjugated conductive polymer comprises at least one polythiophene polymer, preferably poly(3,4-ethylenedioxythiophene)(PEDOT) polymer, doped with at least one water soluble polymeric dopant, preferably polystyrene sulfonic acid (PSS). In this embodiment, the ratio of PEDOT and PSS is preferably 5:95 to 50:50 by weight.

In a certain embodiment, the π-conjugated conductive polymer is used in the amount of 0.01 to 1.0 wt %, preferably 0.05 to 0.2 wt %, relative to the total weight of the composition. A composition according to the present invention comprising the π-conjugated conductive polymer in the amount of 0.01 to 1.0 wt % relative to the total weight of the composition, can exhibit particularly good conductivity and transparency.

In the present invention, the PEDOT:PSS co-doped with *para*-toluene sulfonic acid is especially preferred.

Without wishing to be bound by any theory, incorporation of the π-conjugated conductive polymer into the composition comprising at least one metal nanowires may prevent oxidation and/or degradation of the metal nanowires and/or it conductive network. Also, such incorporation allows increased conductivity compared to the conductive system solely based on the metal nanowire network.

In the present invention, the compositions of the present invention comprise at least one metal nanowires. When deposited on the substrate, the nanowires are usually present so as to intersect each other to form a conductive metal nanowire network having plurality of intersections of metal nanowire.

In the present invention, an average diameter of the metal nanowires is from 10 nm to 50 nm, preferably 15 nm to 35 nm, more preferably 18 nm to 23 nm. In the present invention, the diameter of the metal nanowires can be measured by transmission electron microscope (TEM). An average length of the metal nanowires in the present invention is often in the range of 1 µm to 100 µm. The average length of the metal nanowires is preferably at least 10 µm, more preferably more than 10 µm, still more preferably at least 15 µm. The average length of the metal nanowires is preferably equal to or less than 50 µm, more preferably equal to or less than 30 µm, still more preferably equal to or less than 20 µm. In the present invention, the length of the metal nanowires can be measured by optical microscope.

In the present invention, the metal nanowires can be nanowires formed of metal, metal alloys, plated metals or metal oxides. Examples of the metal nanowires include, but are not limited to, silver nanowires, gold nanowires, copper nanowires, nickel nanowires, gold-plated silver nanowires, platinum nanowires, and palladium nanowires. The metal nanowires in the composition according to the present invention preferably comprise silver nanowires. Silver nanowires are the most preferred metal nanowires in the present invention because of its high electrical conductivity.

Excellent result can be obtained when silver nanowires having an average diameter of 18 nm to 23 nm and an average length of 10 to 25 µm are used in the composition according to the present invention.

Such silver nanowires may be prepared via the synthesis methods known in the art. For instance, so-called "polyol method" may be used for the synthesis of the silver nanowires to be used in the present invention. Reference can be made to Sun et al., "Crystalline silver nanowires by soft solution processing", Nanoletters, (2002), 2(2) 165-168.

In a particular embodiment of the present invention, the metal nanowires are used in the amount of 0.01 to 1.0 wt %, preferably 0.05 to 0.2 wt %, relative to the total weight of the composition. The composition according to the present invention comprising the metal nanowires in the amount of 0.01 to 1.0 wt % relative to the total weight of the composition, can exhibit particularly good conductivity, transparency and/or haze.

In the present invention, the ratio between the π-conjugated conductive polymer and the metal nanowires in the composition is preferably 1:0.5~1:5, more preferably 1:1~1:3. The composition according to the present invention comprising the π-conjugated conductive polymer and the metal nanowires in said range may attain well-balanced conductivity and optical properties.

In the present invention, the composition may comprise at least one binder. The binder in the present invention may be an organic compound, an inorganic compound, or a hybrid compound thereof. Examples of the organic binder include polyesters, such as polyethylene terephthalate, polybutylene terephthalate, and polyethylene naphthalate; polyimides, such as polyimide, and polyamideimide; polyamides, such as polyamide 6, polyamide 6,6, polyamide 12, and polyamide 11; fluororesins, such as polyvinylidene fluoride, polyvinyl fluoride, polytetrafluoroethylene, ethylenetetrafluoroethylene copolymer, and polychlorotrifluoroethylene; vinyl resins, such as polyvinyl alcohol, polyvinyl ether, polyvinyl butyral, polyvinyl acetate, and polyvinyl chloride; epoxy resin; oxetane resin; xylene resin; aramide resin; polyimide silicon; polyurethane; polyurea; melamine resin; phenol resin; polyether; organosilicons; poly(ethylene oxide)s (PEO); silicon(Si)-based binder, such as aminosilane-based binders, and tetraalkoxysilane-based binders; acrylic resin, and their copolymers.

In the present invention, the binder, when present, is typically used in an amount of 0.01 to 1.0 wt %, preferably 0.05 to 0.2 wt %, relative to the total weight of the composition.

One of the essential features of the present invention resides in using at least one amine compound having a boiling point of at least 180 °C in the composition of the present invention. Without wishing to be bound by any theory, it is believed that by incorporating this particular amine compound functions as a pH control agent for π-conjugated conductive polymer which usually exists in an acidic status, oxidation and/or degradation of metal nanowires in the same composition when contacted with the π-conjugated conductive polymer often possessing highly acidic nature can be prevented or substantially reduced. The compositions according to the present invention which comprise said amine compound can attain a stable degree of dispersion as having good miscibility between π-conjugated conductive polymer and metal nanowires. In addition, the incorporation of said amine compound enables an extended shelf-life during delivery and storage.

In the present invention, the amine compound which has boiling point of at least 180 °C can be used. The boiling point of the amine compound is preferably at least 190 °C, more preferably at least 195 °C. The maximum boiling point may be as high as about 300 °C (e.g. in case of glycol amine). The boiling point of the amine compound can be no more than 290 °C. The amine compounds which have a boiling point of at least 180 °C as well as exhibit an anti-corrosion effect are particularly preferred in the present invention. The amine compounds often having an excellent solubility in water are often preferred, for instance, in view of their good processability during the formulation preparation. In the present invention, the amine compound is preferably present in liquid state at room temperature. In the present invention, said amine compound preferably comprises at least one group other than the amine group, the group which confers sufficient solubility in water. Particular example of such group includes alcohol group.

Suitable class of the amine compound includes alkanol amines, such as monoalkanol amines, dialkanol amines, and trialkanol amines. From the point of commercial availability, ethanol amines and propanol amines may be used as the amine compound in the present invention. Among the ethanol amines, N-substituted monoethanol amines, unsubstituted or N-substituted diethanol amines and unsubstituted or N-substituted triethanol amines are preferred. Particular examples of the ethanol amines include methyldiethanolamine, n-butylethanolamine, n-buthyldiethanolamine, dibutylethanolamine, cyclohexylethanolamine, cyclohexyldiethanolamine, 4-(2-hydroxyethyl)morpholine, hydroxyethylaniline, ethylhydroxyethylaniline, hydroxyethylpiperidine, dihydroxyethylaniline, and n-propylethanolamine, but the present invention is not limited thereto. Particular examples of the propanol amines include diisopropanolamine, triisopropanolamine, methyldiisopropanolamine, dibutylisopropanolamine, cyclohexylisopropanolamine, cyclooctylisopropanolamine, cyclooctyldiisopropanolamine, 4-(2-hydroxypropyl)morphloline, 3-(2-ethylhexyloxy)-propylamine, aminoethylisopropanolamine, 3-(2-ethylhexyloxy)propylamine, and 3-amino-1-propanol, but the present invention is not limited thereto.

Another class of the amine compound in the present invention includes polyamines. Particular examples of the polyamines include diamines, such as hexamethylenediamine, triamines, such as diethylenetriamine, and tetramines, such as triethylenetetramine, but the present invention is not limited thereto.

Further class of the amine compound in the present invention includes alkoxylated alkylamines. Particular examples of the alkoxylated alkylamines include ethoxylated alkylamines, but the present invention is not limited thereto.

In general, said amine compound can be applied to an aqueous solution of π-conjugated conductive polymer. Particular preferred examples of the amine compound include the product line of trademark SYNERGEX®, such as SYNERGEX® T series, the product commercially available from Taminco.

In a further particular embodiment of the present invention, the amine compound having a boiling point of at least 180 °C is used in the amount of 0.01 to 1.0 wt %, preferably 0.1 to 0.5 wt %, relative to the total weight of the composition. A composition according to the present invention comprising the amine compound having a boiling point of at least 180 °C in said range can exhibit particularly good reliability of conductivity, and/or excellent shelf-life.

The amount of the amine compound can be selected so as to adjust the pH of π-conjugated conductive polymer solution to equal to or more than 7, more preferably to more than 9.

At least one solvent to constitute the composition can be chosen among those selected from the group consisting of water ; aliphatic alcohols, such as methanol, ethanol, isopropanol, butanol, n-propylalcohol, ethylene glycol, propylene glycol, butanediol, neopentyl glycol, 1,3-pentanediol, 1,4-cyclohexanedimethanol, diethyleneglycol, polyethelene glycol, polybutylene glycol, dimethylolpropane, trimethylolpropane, sorbitol, esterification products of the afore-mentioned alcohols ; aliphatic ketones, such as cellosolve, propyleneglycol methylether, diacetone alcohol, ethylacetate, butylacetate, acetone and methylethylketone ; ethers such as tetrahydrofuran, dibutyl ether, mono- and polyalkylene glycol dialkyl ethers ; aliphatic carboxylic acid esters ; aliphatic carboxylic acid amides ; aromatic hydrocarbons ; aliphatic hydrocarbons ; acetonitrile ; aliphatic sulfoxides ; and any combination thereof. Water and/or alcohols can be preferably used.

Optionally, the composition according to the present invention may contain one or more additives known in the art. Reference can be made to the disclosure of the United States Patent Application Publication No. US 2014/0203223 A.

Another aspect of the present invention concerns methods for preparing the composition according to the present invention. Such method comprises (a) preparing a first solution comprising (A) at least one metal nanowires; (b) preparing a second solution comprising (B) at least one π-conjugated conductive polymer and (C) at least one amine compound having a boiling point of at least 180 °C; and (c) mixing the first solution and the second solution to obtain the composition. One or more of the above-explained solvents may be used to form the first solution and/or the second solution.

The method for preparing the composition according to the present invention preferably comprises adjusting the pH level of a solution of (B) at least one π-conjugated conductive polymer to over pH 9. It has been surprisingly found that by controlling the pH of the conductive polymer to such degree, exceptionally advantageous reliability of the transparent conductor can be obtained. Thus, the present invention further concerns compositions comprising (B) at least one π-conjugated conductive polymer; (C) at least one amine compound having a boiling point of at least 180 °C; and (D) at least one solvent; wherein pH of the composition is more than 9. Reference can be made to the foregoing description for further details and preferred scope for each component.

The composition according to the present invention may be advantageously used for forming a transparent conductor. Thus, further aspect of the present invention relates to transparent conductors obtainable or obtained by using the composition according to the present invention.

The transparent conductor may comprise at least one conductive layer on the surface of a substrate, the conductive layer comprising:
(A) at least one metal nanowires;
(B) at least one π-conjugated conductive polymer; and
(C) at least one amine compound having a boiling point of at least 180 °C.

The transparent conductor according to the present invention can attain excellent one or more optical and electrical properties which are often required for various applications of such transparent conductor. Accordingly, the transparent conductor of the present invention may possess at least one, preferably two, more preferably all of the following characteristics:
- a transparency to visible light of at least 80%, preferably at least 88%, more preferably at least 90%
- a sheet resistance of no more than 500 Ω/square, preferably no more than 150 Ω/square, more preferably no more than 80 Ω/square
- a haze of no more than 2%, preferably no more than 1.5%, more preferably no more than 1%

In the present invention, the transparency (transmission) to visible light can be measured by using UV-VIS spectrometer at wavelength range from 400 nm to 800 nm. For instance, Haze-gard plus instrument (transparency function) available from BYK-Gardner (ASTM D 1003) can be used.

In the present invention, the sheet resistance can be measured using 4-point probes using R-CHEK Surface Resistivity Meter (Model #RC3175) available from EDTM Inc.

In the present invention, the haze can be measured using a haze-meter, for instance Haze-gard plus instrument available from BYK-Gardner (ASTM D 1003).

The present invention can provide a transparent conductor comprising both metal nanowires and π-conjugated conductive polymer, the transparent conductor having exceptionally superior and balanced optical and electrical properties as well as reliability thereof for an extended time period.

The transparent conductor according to the present invention may be subject to one or more subsequent fabrication process. For instance, the transparent conductor can be patterned and/or over-coated with one or more layer. For the methodologies of the patterning, reference can be made to the disclosures of the United States Patent Application Publication No. US 2014/0203223 A, which, by its entirety, is incorporated herein by reference.

The transparent conductor of the present invention and/or its fabricated structure, especially patterned structure thereof, can be used in various electronic devices in which a transparent conductor is suitably utilized. Examples of the application include touch panels, various electrodes for display devices, such as liquid crystal display (LCD) and organic light-emitting device (OLED), antistatic layers, electromagnetic interference (EMI) shields, touch-panel-embedded display devices, and photovoltaic (PV) cells, but the present invention is not limited thereto. The transparent conductor of the present invention is particularly useful when used in touch panel applications.

Thus, still further aspect of the present invention concerns an electronic device at least comprising the transparent conductor according to the present invention.

The transparent conductor according to the present invention may be manufactured by forming a conductive layer on the surface of a substrate, the conductive layer being formed by using the composition of the present invention. As such, yet further aspect of the present invention concerns a method for manufacturing preparing a transparent conductor from the composition according to the present invention. Such method often comprises (a) evenly applying the composition according to the present invention on the surface of a substrate, and (b) curing the composition applied on the surface. Examples of such method of applying the composition on the substrate include wettings, such as dipping, coatings, such as spin coating, dip coating, slot-die coating, spray coating, flow coating, bar coating, meniscus coating, capillary coating, roll coating, and electro-deposition coating, and spreading, but the present invention is not limited thereto. The thickness of the conductive layer on the substrate is preferably from 300 to 3,000 Å, more preferably 500 to 2,000 Å. Drying may be performed under air or under inert atmosphere such as nitrogen or argon. Drying is typically conducted under atmospheric pressure or under reduced pressure, particularly under atmospheric pressure. Drying is usually conducted at a temperature sufficiently high to allow evaporation of the solvent. Drying may be performed at a temperature between 10 to 200 °C depending on selection of the solvent. Optional curing can be conducted by a subsequent treatment, such as a heat treatment and/or a treatment with radiation. Preferably, ultraviolet(UV) radiation in particular with a wavelength ranging from 100 nm to 450 nm, for example 172, 248 or 308 nm, can be suitably used. One or more optional treatment step, such as cleaning, drying, heating, plasma treatment, microwave treatment, and ozone treatment, may be conducted in any time during the process for the manufacture of transparent conductor.

The following examples illustrate the invention in further detail without however limiting it.

### Examples

### Example 1: Preparation of PEDOT formulation

350 g of PEDOT:PSS (1wt % Verasol WED-SM from SOKEN) was charged in 2 L wessel, and then 100 g of isopropyl alcohol, 50 g of dimethyl sulfoxide, and 500 g of deionized water were further added. The mixture was stirred by direct stirrer at 80 rpm~100 rpm. The amine compound (as described in the following Table 1) was added as pH control agent to adjust the pH of the mixture from low pH to over 9 pH. This mixture had 0.35 wt % solid contents.

**[Table 1: B.P. and used amount of the amine compound in each PEDOT formulation]**

| | Sample 1 | Sample 2 | Sample 3 | Sample 4 |
|---|---|---|---|---|
| | Ammonia water | Triethyl amine | 2-ethylamino ethanol | SYNERGEX® T (Alkyl alkanol amine) |
| Boil point (B.P.) | 38~100 °C | 88.8 °C | 169 °C | 274 °C |
| The quantity of the compound | 5g | 4.5 g | 7g | 8.3 g |

### Example 2: Preparation of silver nanowires (AgNW) formulations without neutralization (Comparative)

14.25 g of PEDOT:PSS solution without neutralization was added in 250 mL Nalgene bottle, and 60.75 g of deionized water and 10 g of isopropyl alcohol were added. 15 g of AgNW (1 wt % dispersion in water; available from N&B) and 0.07 g of Dynol 607 (from Air-product) as leveling agent were added, and then, the mixture was shaken by vortex mixer. The mixture was shaken by roll-mixer for 2 days.

### Example 3: AgNW formulation with Sample 1 (Comparative)

14.25 g of Sample 1 was added in 250 mL Nalgene bottle, and 60.75 g of deionized water and 10 g of isopropyl alcohol were added. 15 g of AgNW (1 1 wt % dispersion in water; available from N&B) and 0.07 g of Dynol 607 (from Air-product) as leveling agent were added, and then, the mixture was shaken by vortex mixer. The mixture was shaken by roll-mixer for 2 days.

### Example 4: AgNW formulation with Sample 2 (Comparative)

14.25 g of Sample 2 was added in 250 mL Nalgene bottle, and 60.75 g of deionized water and 10 g of isopropyl alcohol were added. 15 g of AgNW (1 wt % dispersion in water; available from N&B) and 0.07 g of Dynol 607 (from Air-product) as leveling agent were added, and then, the mixture was shaken by vortex mixer. The mixture was shaken by roll-mixer for 2 days.

### Example 5: AgNW formulation with Sample 3 (Comparative)

14.25 g of Sample 3 was added in 250 mL Nalgene bottle, and 60.75 g of deionized water and 10 g of isopropyl alcohol were added. 15 g of AgNW (1 wt % dispersion in water; available from N&B) and 0.07 g of Dynol 607 (from Air-product) as leveling agent were added, and then, the mixture was shaken by vortex mixer. The mixture was shaken by roll-mixer for 2 days.

### Example 6: AgNW formulation with Sample 4 (Inventive)

14.25 g of Sample 4 was added in 250 mL Nalgene bottle, and 60.75 g of deionized water and 10 g of isopropyl alcohol were added. 15 g of AgNW (1 wt % dispersion in water; available from N&B) and 0.07 g of Dynol 607 (from Air-product) as leveling agent were added, and then, the mixture was shaken by vortex mixer. The mixture was shaken by roll-mixer for 2 days.

### Evaluation of formulation of AgNW mixed with PEDOT:PSS

Each formulation was coated on PET film by bar coater (#7). The properties shown in the following Table 2 were measured. The baking condition thereof was 60 sec at 130 °C.

Transmittance and haze were measured by averaging the value in 9 points on the coated PET film (A4 size) by using, respectively, UV-VIS spectrometer at wavelength range from 400 nm to 800 nm and Haze-gard plus instrument from BYK-Gardner in accordance with ASTM D 1003.

Sheet resistancewas measured by averaging the value in 12 points in the coated PET film (A4 size) with 4-point probes using R-CHEK Surface Resistivity Meter (Model #RC3175) from EDTM Inc.

Coating layer made from each formulation was checked on its sheet-resistance during 7 days. The formulation of Example 6 was most stable on sheet-resistance due to having high vapor pressure.

**[Table 2: Properties of the coating layer from each formulation]**

| | | Example 2 | Example 3 | Example 4 | Example 5 | Example 6 |
|---|---|---|---|---|---|---|
| Transmittance | | 91% | | | | |
| Haze | | 1.12% | | | | |
| Sheet Resistance (Ω/sq) | | 67 | | | | |
| Chan ge on Sheet Resis tance (day) | after 1 | 260 | 180 | 75 | 70 | 70 |
| | after 2 | 400 | 360 | 220 | 270 | 72 |
| | after 3 | 1280 | 800 | 480 | 650 | 68 |
| | after 4 | | 1300 | 900 | 1100 | 71 |
| | after 5 | - | - | - | - | 68 |
| | after 6 | - | - | - | - | 70 |
| | after 7 | - | - | - | - | 68 |

## Claims

1. A composition comprising:
(A) at least one metal nanowires;
(B) at least one π-conjugated conductive polymer;
(C) at least one amine compound having a boiling point of at least 180 °C; and
(D) at least one solvent.

2. The composition according to claim 1, wherein the metal nanowires comprise silver nanowires.

3. The composition according to claim 1 or 2, wherein the π-conjugated conductive polymer is selected from polythiophene polymers, in particular poly(3,4-ethylenedioxythiophene)(PEDOT)/polystyrene sulfonic acid (PSS).

4. The composition according to any one of claims 1 to 3, wherein the amine compound having a boiling point of at least 180 °C is selected from the products of trademark SYNERGEX®.

5. The composition according to any one of claims 1 to 4, comprising the at least one metal nanowires in the amount of 0.01 to 1.0 wt %, preferably 0.05 to 0.2 wt %, relative to the total weight of the composition.

6. The composition according to any one of claims 1 to 5, comprising the at least one π-conjugated conductive polymer in the amount of 0.01 to 1.0 wt %, preferably 0.05 to 0.2 wt %, relative to the total weight of the composition.

7. The composition according to any one of claims 1 to 6, comprising the at least one amine compound having a boiling point of at least 180 °C in the amount of 0.01 to 1.0 wt %, preferably 0.1 to 0.5 wt %, relative to the total weight of the composition.

8. The composition according to any one of claims 1 to 7, wherein the ratio between the π-conjugated conductive polymer and the metal nanowires is 1:0.5~1:5, in particular 1:1~1:3.

9. A method for preparing the composition according to any one of claims 1 to 8, comprising:
(a) preparing a first solution comprising (A) at least one metal nanowires;
(b) preparing a second solution comprising (B) at least one π-conjugated conductive polymer and (C) at least one amine compound having a boiling point of at least 180 °C; and
(c) mixing the first solution and the second solution to obtain the composition.

10. A transparent conductor obtainable or obtained by using the composition according to any one of claims 1 to 8.

11. A transparent conductor comprising at least one conductive layer on the surface of a substrate, the conductive layer comprising:
(A) at least one metal nanowires;
(B) at least one π-conjugated conductive polymer; and
(C) at least one amine compound having a boiling point of at least 180 °C.

12. The transparent conductor according to claim 10 or 11, having at least one of the following characteristics:
- a transparency to visible light of at least 80%, in particular at least 88%, more particularly at least 90%
- a sheet resistance of no more than 500 ohm/square, in particular no more than 150 ohm/square, more particularly no more than 80 ohm/square
- a haze of no more than 2%, in particular no more than 1.5%, more particularly no more than 1%

13. An electronic device at least comprising the transparent conductor according to any one of claims 10 to 12.

14. A process for manufacturing the transparent conductor according to any one of claims 10 to 12, comprising (a) evenly applying the composition according to any one of claims 1 to 8 on the surface of a substrate, and (b) curing the composition applied on the surface.

15. A composition comprising:
(B) at least one π-conjugated conductive polymer;
(C) at least one an amine compound having a boiling point of at least 180 °C; and
(D) at least one solvent;
wherein pH of the composition is more than 9.
